# EUROPÄISCHE PATENTSCHRIFT

(11) **EP 0 586 366 B1**
(45) Veröffentlichungstag und Bekanntmachung des Hinweises auf die Patenterteilung: **06.12.1995**
(21) Anmeldenummer: 93890162.6
(22) Anmeldetag: 23.08.1993
(51) Int. Cl.: C30B 7/10, C30B 29/14, H01L 41/22

(54) **Hydrothermalzuchtverfahren zum Züchten von grossen Kristallen oder Kristallschichten**
Hydrothermal process for the growth of large crystals or crystal layers
Procédé hydrothermique pour la croissance de grands cristaux ou de couches de cristaux

(30) Priorität: 04.09.1992 AT 1780/92
(43) Veröffentlichungstag der Anmeldung: 09.03.1994
(73) Patentinhaber: AVL Gesellschaft für Verbrennungskraftmaschinen und Messtechnik mbH.Prof.Dr.Dr.h.c. Hans List, 8020 Graz (AT)
(72) Erfinder: Krempl, Peter W., Dr., A-8047 Graz/Ragnitz (AT); Voborsky, Gabriele, A-8020 Graz (AT); Posch, Uwe, Dipl.-Ing., A-8020 Graz (AT); Wallnöfer, Wolfgang, A-8045 Graz (AT)
(74) Vertreter: Krause, Walter, Dr. Dipl.-Ing.

(56) Entgegenhaltungen:
- US-A- 4 578 146
- US-A- 4 579 622
- DATABASE WPIL, Nr. 92-339318, DERWENT PUBLICATIONS LTD., London, GB
- DATABASE WPIL, Nr. 93-256934, DERWENT PUBLICATIONS LTD., London, GB

## Beschreibung

Die Erfindung bezieht sich auf ein Hydrothermalzuchtverfahren zum Züchten von gropen Kristallen oder Kristallschichten aus einem Metallorthophosphat, insbesondere Galliumphosphat (GaPO₄) oder Aluminiumphosphat (AlPO₄), aus einer Zuchtlösung unter Verwendung einer Keimplatte.

Einkristalle aus bestimmten Metallorthophosphaten, z.B. GaPO₄ oder AlPO₄ (auch als Berlinit bezeichnet) haben, insbesonders als piezoelektrische Kristalle, wegen der gegenüber Quarz für viele Anwendungen verbesserten Eigenschaften, (z.B. bessere Hochtemperatureignung) in den letzten Jahren immer mehr Beachtung gefunden und es werden grope Anstrengungen unternommen um die Kristalle in technisch interessanten Mengen und Größen herzustellen. Die größte Schwierigkeit bei der Herstellung dieser Kristalle bereitet das Fehlen von natürlich gewachsenen Kristallen, aus denen wie bei Quarz große und qualitativ hochwertige Keimplatten für die Kristallzucht, welche hauptsächlich mit hydrothermalen Methoden durchgeführt wird, gewonnen werden konnen. Bei der Zucht aus der Schmelze (CZOCHRALSKY-Verfahren) erhält man diese Metallorthophosphate nicht in der gewünschten Kristallstruktur mit der kristallographischen Punktgruppe 32.

Die sukzessive Aufzucht von Metallorthophosphat-Kristallen aus zunächst nur kleinen Spontankristallen bereitet wegen der Neigung zur Zwillingsbildung an der Anwachsstelle große Schwierigkeiten und ist ein sehr zeitraubendes und mit nur geringer Erfolgsaussicht durchzuführendes Verfahren. Es wurden daher spezielle Methoden gesucht, mit denen man größere Keimplatten erhalten kann. So wurde z. B. in der US-PS 4,578.146 ein Verfahren zur Erzeugung groper Keimplatten durch das Aufzüchten von Kristallen aus aneinandergefügten kleinen Keimplatten angegeben. Dieses Verfahren bringt zwar eine wesentliche Beschleunigung bei der Erzeugung großer Keimplatten setzt jedoch die Existenz synthetisch erzeugter Metallorthophosphat-Kristalle voraus.

Der Erfindung liegt also die Aufgabe zugrunde, ein Verfahren anzugeben, mit welchem die Züchtung qualitativ hochwertiger, großer Metallorthophosphat-Kristalle möglich ist.

Diese Aufgabe wird gemäß dieser Erfindung dadurch gelöst, daß in der Startphase des Zuchtverfahrens eine Keimplatte aus Alpha-Quarz (α-SiO₂) in die Zuchtlösung eingesetzt wird, und daß der Zuchtlösung zumindest zur Bildung der ersten Kristallschicht auf der Quarzkeimplatte Fluoridionen (F⁻) zugegeben werden, wobei unter Alpha-Quarz die in der kristallographischen Punktgruppe 32 kristallisierende, bis zu einer Temperatur von 573°C stabile Modifikation von Quarz zu verstehen ist.

Überraschenderweise hat sich gezeigt, daß entgegen der bisherigen Ansicht Keimplatten aus Alpha-Quarz für die Kristallzucht von Metallorthophosphaten verwendet werden können, wenn der Zuchtlösung geringe Mengen von Fluoridionen zugesetzt werden. Da Keimplatten aus Quarz in vielen Formen und Größen relativ billig erhältlich sind, können mit dem neuen Verfahren auf einfache Weise große Orthophosphat-Kristalle hoher Güte hergestellt werden.

Als Funktionsprinzip ist folgender Mechanismus denkbar: Durch den Zusatz von Fluoridionen zur Zuchtlösung wird offenbar das Anwachsen von einkristallinen Metallorthophosphat-Schichten auf bestimmten Flächen von Alpha-Quarz ermöglicht.

Erfindungsgemäß ist es gemäß einer ersten Ausführungsvariante möglich, daß die Zucht bis zur Bildung eines Metallorthophosphat-Kristalls gewünschter Form und Größe in der mit Fluoridionen versetzten Zuchtlösung fortgesetzt wird.

In einer zweiten Ausführungsvariante des Verfahrens ist vorgesehen, daß die Kristallzucht nach Bildung einer epitaxialen Metallorthophosphat-Schicht auf der Keimplatte beendet wird und daß die mit einer Metallorthophosphat-Schicht versehene Keimplatte als Keimplatte in einem beliebig anderen, bekannten Verfahren zur Züchtung von Metallorthophosphat-Kristallen verwendet werden kann. Ein derartiges Verfahren besteht im wesentlichen aus 2 Schritten. 1. Schritt: Epitaxie auf Quarz, 2. Schritt: Züchten des restlichen Einkristallbereiches mit einem anderen Verfahren.

Die Fluoridionen können erfindungsgemäß in der Form von 0.01 bis 10 Gewichtsprozent Ammoniumfluorid (NH₄F) oder Ammoniumhydrogendifluorid ((NH₄)HF₂) in die Zuchtlösung eingebracht werden. Es ist jedoch auch möglich,daß die Fluoridionen in der Form von Flupsäure (HF),Lithium-, Natrium-, oder Kaliumfluorid (LiF, NaF oder KF) in die Zuchtlösung eingebracht werden.

Besonders vorteilhaft wird das neue Verfahren als Hydrothermalzuchtverfahren durchgeführt, wobei die Kristallzucht in geschlossenen Gefäßen bei erhöhtem Druck und erhöhter Temperatur erfolgt.

Insbesondere ist erfindungsgemäß vorgesehen, daß eine Zuchtlösung aus mit dem Metallorthophosphat übersättigter 2 bis 15 molarer Phosphorsäure (H₃PO₄) verwendet wird und die Kristallzucht bei Temperaturen über 150°C, vorzugsweise 180 bis 240°C, betrieben wird.

Eine besonders vorteilhafte Ausführungsvariante sieht vor, daß Keimplatten aus Alpha-Quarz eingesetzt werden, deren größte Fläche im wesentlichen senkrecht zur optischen Achse (z- oder c-Achse) der Quarzplatte ausgerichtet ist.

Ein qualitativ besonders gutes Aufwachsen wird auf Quarzflächen senkrecht zur optischen Achse des Quarzkristalles, den sogenannten z-Flächen, erzielt. Auch auf x-Flächen, also Flächen welche senkrecht zur elektrischen Achse (x-Achse) des Quarzkristalls stehen, können in der genannten Züchtlösung Metallorthophosphate auf Quarz aufwachsen.

Obwohl der wichtigste Vorteil dieses Verfahrens in der Möglichkeit Keimplatten aus Quarz einzusetzen liegt, zeigt sich jedoch auch, daß größere Wachstumsgeschwindigkeiten bei gleichzeitig verbesserter Kristallqualität erzielt werden können. So ist es überraschend, daß das auf Quarz aufgewachsene Kristallmaterial aus z.B. Galliumphosphat (GaPO₄) zwillingsfrei ist, was nur sehr selten bei Spontankristallen aus GaPO₄ oder gar bei der Weiterzucht von Ga-Orthophosphat auf Keimplatten aus GaPO₄ beobachtet wird. Dies steht im Widerspruch zur allgemeinen Annahme, daß ein einkristallines Material am störungsfreiesten auf Keimplatten aus dem gleichen Material wächst.

Weiters können aus dem Metallorthophosphat-Kristall unter Vermeidung der Quarz-Keimplatte Metallorthophosphat-Keimplatten geschnitten werden, welche in einem beliebigen anderen, bekannten Verfahren zur Züchtung von Metallorthophosphat-Kristallen verwendet werden.

Von Vorteil ist es dabei insbesondere, daß aus den Metallorthophosphat-Kristallen Keimplatten geschnitten werden, deren gröpte Fläche im wesentlichen senkrecht zur elektrischen Achse (x-Achse) des Metallorthophosphat-Kristalls stehen.

Für besonders anspruchsvolle Zwecke, bei denen eine sehr geringe Versetzungsdichte im einkristallinen Bereich gefordert wird, ist daher folgendes 2-Schrittverfahren sinnvoll: 1. Schritt: Bilden einer ersten Kristallschicht des Metallorthophosphates auf der Quarzkeimplatte unter Zusatz von Fluoridionen und Weiterzucht im gleichen, oder in einem anderen Medium. 2. Schritt: Aus den so gewonnenen Kristallen werden x-Keimplatten, das sind Keimplatten mit der Hauptfläche senkrecht zur elektrischen Achse (x-Achse) geschnitten, welche in einem geeigneten Medium (z.B. einer mit dem Metallorthophosphat übersättigten Schwefelsäurelösung (H₂SO₄), oder einer übersättigten Mischlösung aus Phosphor- (H₃PO₄) und Schwefelsäure (H₂SO₄)) zu den endgültig für die Verwendung vorgesehenen Kristallen weitergezüchtet werden. Da der auf der x-Fläche aufwachsende Teil eine besonders geringe Versetzungsdichte aufweist, wird dadurch die oben gestellte Forderung nach geringer Versetzungsdichte in diesem Kristallbereich erfüllt.

Die Erfindung wird im folgenden anhand von Zeichnungen näher erläutert. Es zeigen:

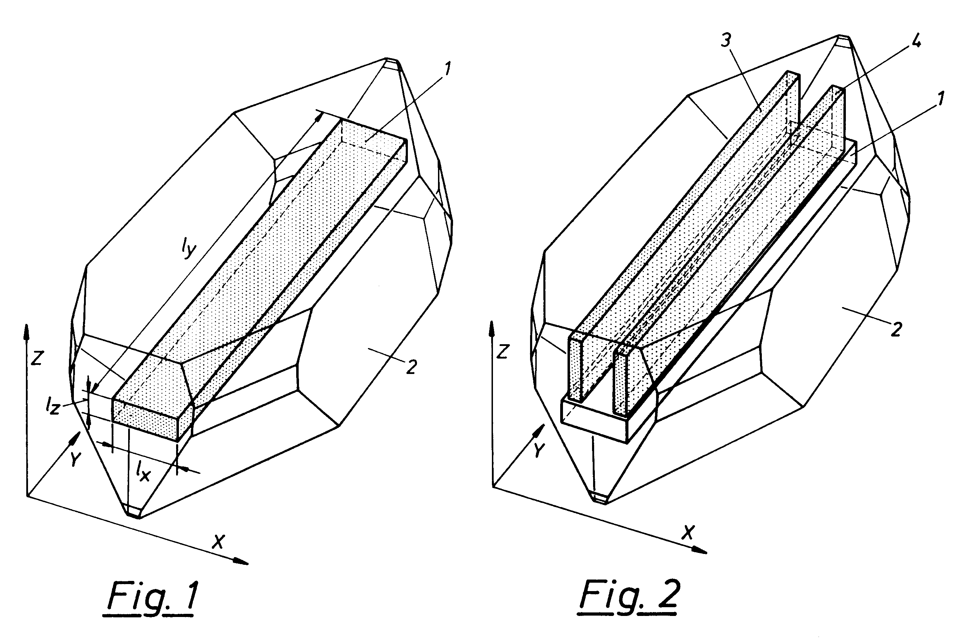

- Fig. 1 und 2: zeigen nach dem erfindungsgemäßen Verfahren hergestellte Metallorthophosphat-Kristalle.

Fig. 1 zeigt eine typische quaderförmige Keimplatte 1 aus Quarz, mit den Längenrelationen 1_{y}>1ₓ>1_{z} und den darauf aufgewachsenen Metallorthophosphat-Kristall 2 im Koordinatensystem x,y,z zur Festlegung der Kristallachsen. In Fig. 2 ist ebenfalls die Keimplatte 1 aus Quarz und der aufgewachsene Kristall 2 aus dem Metallorthophosphat dargestellt. Mit den Bezugszeichen 3 und 4 sind daraus gewinnbare x-Keimplatten für die Züchtung speziell versetzungsfreier Metallorthophosphat-Kristalle gekennzeichnet.

Beispiel zur Herstellung eines Galliumphosphat-Einkristalls:.
Löst man z.B. in einer etwa 12 molaren Phosphorsäure (H₃PO₄) 7 Gewichtsprozent Galliumphosphat (GaPO₄) und etwa 1 Gewichtsprozent Ammoniumfluorid (NH₄F), und bringt in diese Lösung eine Keimplatte aus Alpha-Quarz und erhöht die Temperatur über 150°C, etwa bis 180 oder 240°C, dann erhält man nach mehreren Tagen einen auf der Keimplatte aufgewachsenen GaPO₄-Einkristall mit einer Wachstumsgeschwindigkeit von ca. 0.2 mm/Tag in der z-Richtung.

## Patentansprüche

1. Hydrothermalzuchtverfahren zum Züchten von gropen Kristallen oder Kristallschichten aus einem Metallorthophosphat, insbesondere Galliumphosphat (GaPO₄) oder Aluminiumphosphat (AlPO₄), aus einer Zuchtlösung unter Verwendung einer Keimplatte, **dadurch gekennzeichnet**, daß in der Startphase des Zuchtverfahrens eine Keimplatte aus Alpha-Quarz (α-SiO₂) in die Zuchtlösung eingesetzt wird, und daß der Zuchtlösung zumindest zur Bildung der ersten Kristallschicht auf der Quarzkeimplatte Fluoridionen (F⁻) zugegeben werden.

2. Verfahren nach Anspruch 1, **dadurch gekennzeichnet**, daß die Fluoridionen in der Form von 0.01 bis 10 Gewichtsprozent Ammoniumfluorid (NH₄F) oder Ammoniumhydrogendifluorid ((NH₄)HF₂) in die Zuchtlösung eingebracht werden.

3. Verfahren nach Anspruch 1, **dadurch gekennzeichnet**, daß die Fluoridionen in der Form von Flußsäure (HF),Lithium-, Natrium-, oder Kaliumfluorid (LiF, NaF oder KF) in die Zuchtlösung eingebracht werden.

4. Verfahren nach einem der Ansprüche 1 bis 3, **dadurch gekennzeichnet**, daß eine Zuchtlösung aus mit dem Metallorthophosphat übersättigter 2 bis 15 molarer Phosphorsäure (H₃PO₄) verwendet wird und die Kristallzucht bei Temperaturen über 150°C, vorzugsweise 180 bis 240°C, betrieben wird.

5. Verfahren nach einem der Ansprüche 1 bis 4, **dadurch gekennzeichnet**, daß die Zucht bis zur Bildung eines Metallorthophosphat-Kristalls gewünschter Form und Größe in der mit Fluoridionen versetzten Zuchtlösung fortgesetzt wird.

6. Verfahren nach einen der Ansprüche 1 bis 4, **dadurch gekennzeichnet,** daß die Kristallzucht nach Bildung einer epitaxialen Metallorthophosphat-Schicht auf der Keimplatte beendet wird und daß die mit einer Metallorthophosphat-Schicht versehene Keimplatte als Keimplatte in einen beliebigen anderen, bekannten Verfahren zur Züchtung von Metallorthophosphat-Kristallen verwendet wird.

7. Verfahren nach einem der Ansprüche 1 bis 6, **dadurch gekennzeichnet,** daß Keimplatten aus Alpha-Quarz eingesetzt werden, deren größte Fläche im wesentlichen senkrecht zur optischen Achse (z- oder c-Achse) der Quarzplatte ausgerichtet ist.

## Claims

1. A hydrothermal process for growing large crystals or crystal layers of a metal orthophosphate, in particular gallium phosphate (GaPO₄) or aluminum phosphate (AlPO₄), from a nutrient solution with the use of a seed plate, wherein a seed plate of alpha- quartz (α-SiO₂) is introduced into the nutrient solution in the initial phase of the growth process, and wherein fluoride ions (F⁻) are added to the nutrient solution, at least for formation of the primary crystal layer on the quartz seed plate.

2. A process as in claim 1, wherein the fluoride ions are added to the nutrient solution in the form of 0.01 to 10 percent by weight ammonium fluoride (NH₄F) or ammonium hydrogen difluoride ((NH₄)HF₂).

3. A process as in claim 1, wherein the fluoride ions are added to the nutrient solution in the form of hydrofluoric acid (HF), or as lithium-, sodium-, or potassium fluoride (LiF, NaF, or KF).

4. A process as in any of claims 1 to 3, wherein a nutrient solution of 2 to 15 M phosphoric acid (H₃PO₄) supersatured in the metal orthophosphate is used and crystal growth takes place at temperatures exceeding 150°C, preferably 180 to 240°C.

5. A process as in any of claims 1 to 4, wherein the growth process is continued until a metal orthophosphate crystal of the desired shape and size has formed in the nutrient solution enriched with fluoride ions.

6. A process as in any of claims 1 to 4, wherein crystal growth is stopped once an epitaxial layer of metal orthophosphate has been deposited on the seed plate, and wherein the seed plate coated with this layer of metal orthophosphate is used as a seed plate with some other known method for growing metal ortho- phosphate crystals.

7. A process as in any of claims 1 to 6, wherein seed plates of alpha-quartz are used whose largest face is essentially perpendicular to the optical axis (Z- or C-axis) of the quartz plate.

## Revendications

1. Procédé de culture hydrothermale pour la culture de grands cristaux ou de couches cristallines provenant d'un orthophosphate métallique, en particulier du phosphate de gallium (GaPO₄) ou du phosphate d'aluminium (AlPO₄), à partir d'une solution de culture en utilisant une plaque de germination, caractérisé en ce que, dans la phase de démarrage du procédé de culture on introduit une plaque de germination en quartz alpha (α-SiO₂) dans la solution de culture et en ce qu'on ajoute des ions fluorure (F⁻) à la solution de culture au moins pour la formation de la première couche de cristaux sur la plaque de germination de quartz.

2. Procédé selon la revendication 1, caractérisé en ce que des ions fluorure sous forme de 0,01 à 10 pourcent en poids de fluorure d'ammonium (NH₄F) ou de difluorure d'hydrogène d'ammonium (NH₄)HF₂) sont introduite dans la solution de culture.

3. Procédé selon la revendication 1, caractérisé en ce que les ions fluorures sont introduits dans la solution de culture sous la forme d'acide fluorhydrique (HF), de fluorure de lithium, de sodium ou de potassium (LiF, NaF ou KF).

4. Procédé selon une des revendications 1 à 3, caractérisé en ce qu'on utilise une solution de culture d'acide phosphorique (H₃PO₄) sursaturé avec l'orthophosphate métallique, de 2 à 15 polaire et on conduit la culture des cristaux à des températures au-dessus de 150°C, de préférence de 180 à 240°C.

5. Procédé selon une des revendications 1 à 4, caractérisé en ce que la culture jusqu'à la formation d'un cristal d'orthophosphate métallique de forme et de dimension souhaitées est continuée dans la solution de culture mélangée avec des ions fluorure.

6. Procédé selon une des revendications 1 à 4, caractérisé en ce que la culture de cristaux est terminée après la formation d'une couche d'orthophosphate métallique épitaxiale sur la plaque de germination et en ce que la plaque de germination munie d'une couche d'orthophosphate métallique est utilisée comme plaque de germination dans un autre, quelconque procédé connu pour la culture de cristaux d'orthophosphate métallique.

7. Procédé selon une des revendications 1 à 8, caractérisé en ce qu'on met en oeuvre des plaques de germination en quartz alpha dont la face la plus grande est orientée perpendiculairement à l'axe optique (avec z ou axe c) de la plaque de quartz.
